# EUROPEAN PATENT APPLICATION

(11) **EP 4 730 938 A1**
(43) Date of publication of application: **22.04.2026**
(21) Application number: 25203438.4
(22) Date of filing: 19.09.2025
(51) Int. Cl.: H05K 7/20

(54) **PLATE HEAT EXCHANGER WITH LIQUID BACKFLUSH CIRCUIT**

(30) Priority: 20.09.2024 US 202463697345 P; 18.09.2025 US 202519333067
(71) Applicant: Vertiv Corporation, Westerville, OH 43082 (US)
(72) Inventor: KOVAL, Nathan D., Westerville, 43082 (US); BLASER, Colin Lewis, Westerville, 43082 (US); RAVEN, Matthew Alan, Westerville, 43082 (US); BREUER, Thomas C., Westerville, 43082 (US); MILLER, Oliver McKenzey, Westerville, 43082 (US)
(74) Representative: Bryn-Jacobsen, Caelia

(57) **Abstract**

In a present example, a thermal cooling system can include a liquid-cooling circuit, a heat exchanger, and a liquid flush circuit. The liquid-cooling circuit can be configured to convey a cooling fluid therethrough. The heat exchanger can be fluidly coupled with the liquid-cooling circuit. The liquid flush circuit can be fluidly coupled with the liquid-cooling circuit, and the liquid flush circuit can include a filter. The liquid flush circuit can be configured to selectively operate in a normal cooling operation mode or in a flushing mode. The flushing mode can be configured to cause the cooling fluid to divert through the liquid flush circuit and the heat exchanger to cause the cooling fluid to flow through the filter after passing through the heat exchanger.

## Description

### CROSS-REFERENCE TO RELATED APPLICATIONS

The present application claims priority to U.S. Provisional Patent Application Number 63/697,345, filed September 20, 2024.

### BACKGROUND

Liquid cooling applications are becoming more predominant in data centers given that the heat removal requirement generally exceeds the capability of air. Heat exchanger fouling (e.g., clogging) can be a significant problem, particularly with plate heat exchangers due to the tight clearances. Fouling can inhibit heat transfer which results in reduced efficiency and higher energy costs for the data center. There are many methods to eliminate fouling, but one of the most common is a manual backflushing process, which involves decommissioning the system, disconnecting the inlet/outlet pipes, and manually reversing the flow direction in the liquid side of the heat exchanger. Once complete, the system then needs to be refilled to capacity and purged of air. This maintenance procedure can result in significant downtime and labor for the data center. Therefore, there is a need for systems and methods that reduce the downtime and labor for backflushing than what is currently available.

### SUMMARY

In an example of the present disclosure, a thermal cooling system can include a liquid-cooling circuit, a heat exchanger, and a liquid flush circuit. The liquid-cooling circuit can be configured to convey a cooling fluid therethrough. The heat exchanger can be fluidly coupled with the liquid-cooling circuit. The liquid flush circuit can be fluidly coupled with the liquid-cooling circuit, and the liquid flush circuit can include a filter. The liquid flush circuit can be configured to selectively operate in a normal cooling operation mode or in a flushing mode. The flushing mode can be configured to cause the cooling fluid to divert through the liquid flush circuit and the heat exchanger to cause the cooling fluid to flow through the filter after passing through the heat exchanger.

In an example of the present disclosure, a system can include a liquid flush circuit fluidly couplable to a liquid cooling circuit of a thermal cooling system, wherein the liquid cooling circuit includes a heat exchanger. In one or more examples, the liquid cooling circuit includes a fluid interconnection and a filter, wherein the liquid flush circuit is configured to selectively operate in a normal cooling operation mode or in a flushing mode, the flushing mode configured to cause the cooling fluid to divert through the liquid flush circuit and the heat exchanger to cause the cooling fluid to flow through the filter after passing through the heat exchanger.

In an example of the present disclosure, a method may include switching a first set of valves on a first divergent section of the liquid flush circuit from a normal cooling operation configuration to a flushing configuration. In one or more examples, the method may include switching a second set of valves on a second divergent section of the liquid flush circuit from an isolation configuration to a flush configuration. In one or more examples, the method may include switching 1) the first set of valves from the flushing configuration to a normal cooling operation configuration, and 2) the second set of valves from the flush configuration to the isolation configuration, wherein switching the first set of valves from the flushing configuration to a normal cooling operation configuration.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The detailed description is described with reference to the accompanying figures. The use of the same reference numbers in different instances in the description and the figures may indicate similar or identical items. Various examples or examples ("examples") of the present disclosure are disclosed in the following detailed description and the accompanying drawings. The drawings are not necessarily to scale. In general, operations of disclosed processes may be performed in an arbitrary order, unless otherwise provided in the claims.
FIG. 1 illustrates a schematic view of a liquid-based thermal cooling system, in accordance with an example of the present disclosure.
FIG. 2 illustrates a block diagram depicting a thermal cooling system 100a, in accordance with one or more examples of the disclosure.
FIG. 3 illustrates a process flow diagram depicting a method 300 for backflushing a portion of a thermal cooling system 100, 100a, in accordance with one or more examples of the disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "examples" means that a particular element, feature, structure, or characteristic described in connection with the example is included in at least one example disclosed herein. The appearances of the phrase "in examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

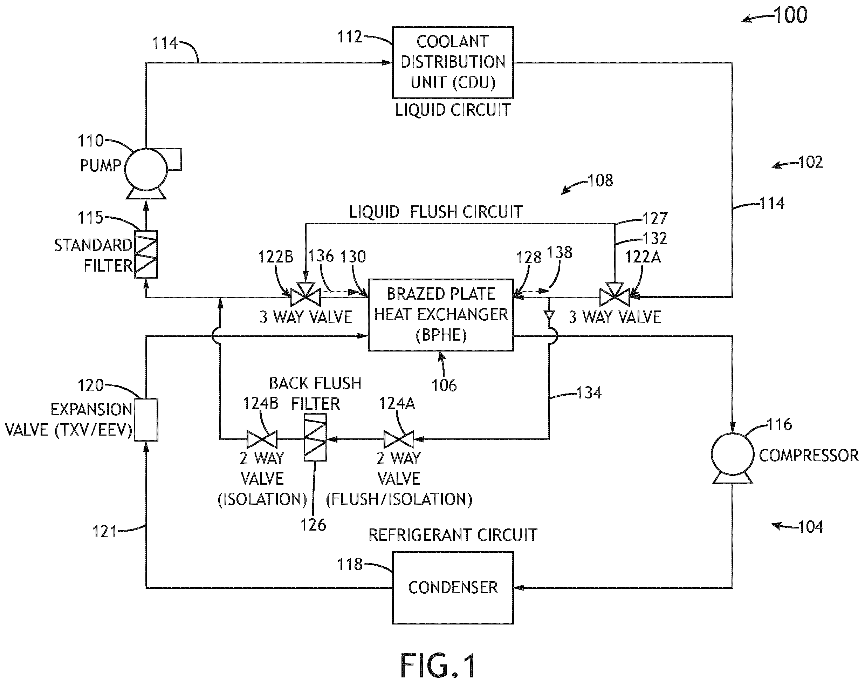

Heat is produced by servers/chips in the data center is transferred to and otherwise warms a previously-cooled liquid (e.g., a first fluid associated with a liquid-cooling circuit) that is circulated in the liquid circuit, as shown in FIG. 1. The heat of the now-warmed liquid (e.g., the first fluid) in this liquid circuit is exchanged with a cool refrigerant (e.g., a second fluid associated with a refrigeration circuit) in a countercurrent flow across the brazed plate heat exchanger. The cooling capacity of the refrigerant fluid is essentially transferred to the cooling circuit fluid (e.g., the first fluid of the liquid-cooling circuit) at the brazed plate heat exchanger (e.g., by warming the refrigerant fluid and inducing a liquid-to-gas phase change therein).

The now-regained cooling capacity of the cooling circuit fluid is ultimately removed (e.g., by warming the cooling circuit fluid) in the coolant distribution unit (before being recirculated once more to the brazed plate heat exchanger to again be cooled by the refrigerant fluid). The warmed refrigerant fluid can once again be cooled upon being circulated through a compressor and condenser associated with the refrigerant circuit. That is, a thermal heat exchange system can employ two distinct fluids to facilitate the heat exchange process, with the first fluid in a cooling cycle/loop, with the cooling cycle permitting cooling of, for example, data center components, and the second fluid in a refrigerant cycle/loop that can ultimately "resupply" the cooling capability to the first fluid (e.g., the liquid of the liquid-cooling circuit).

Fouling/clogging of a cooling system, particularly within a brazed plate heat exchanger, can be a legitimate concern. Over many weeks or months of normal operation, fouling can build-up inside the liquid side (e.g., the cooling circuit fluid side) of the brazed plate heat exchanger due to scaling, corrosion, other particulates, or microorganisms. That is, the kinetic increase in the cooling circuit fluid at the brazed plate heat exchanger can promote one or more of turbulence (e.g., promoting scaling); increased oxidation (e.g., greater corrosion); and/or promotion of biological growth. This build-up can ultimately result in a reduced heat transfer coefficient, which lowers the efficiency of the system, which in turn can require a larger energy input to achieve the same heat transfer. In addition to this, fouling can increase the pressure drop across the heat exchanger, which can increase the liquid pump's energy expenditure and/or possibly drive a more frequent need for repair and/or replacement thereof.

The present liquid-cooling based heat exchanger or thermal cooling system, as illustrated in FIG. 1 in accordance with an example of the present disclosure, can provide a backflush circuit that allows a data center to be able to perform the backflush procedure more quickly, safely, and easily than the conventional method. By changing the position of two three valves and one primary two-way valve associated with the current backflush circuit, the liquid flow direction can be reversed through the heat exchanger, and liquid can be routed through the backflush circuit featuring a filter, allowing any freed contaminant (e.g., potential fouling material) to be captured in the filter. In an example, an increased pressure flow may be used in the backflush process to help promote freeing of any contaminants from the brazed plate heat exchanger. In an example, a controller may be implemented to facilitate automatic control of the valves associated with this system, and the system may incorporate one or more sensors to monitor process parameters in the liquid and/or refrigerant circuits (e.g., pressure drop across the heat exchanger; flow rate in the liquid circuit and/or the refrigerant circuit; suction pressure of the refrigerant; etc.) to dictate to the controller when a backflush procedure is to be implemented.

Since this circuit is incorporated into the design, pipes do not have to be disconnected, and the system does not require refilling/purging. Such a simplification of the backflush maintenance procedure allows the data center to seamlessly transition between operation and maintenance, reducing downtime and labor hours. It is to be understood that the backflush circuit can further include a set of two-way valves, one on either side of the filter, to facilitate changing and/or cleaning of the filter periodically without a need to shut down the entire system.

When fouling needs to be addressed in the present system, the positions of the two three-way valves and the primary two-way valve are switched to redirect the inlet liquid flow to the heat exchanger's liquid outlet (e.g., instead of the inlet thereof) when implementing the backflush circuit. Any material freed by the backflush is captured in a filter before liquid is circulated back through the pump and remaining circuit. Once the procedure is completed, the valve positions can be reverted to their original positions, and the system can resume normal operation. Thus, the present liquid backflush circuit and related backflush procedure allow the heat exchanger to be backflushed and cleaned with ease, requiring significantly less time. The backflushing procedure can be initiated quickly by changing the valve positions, without disconnecting pipes, and without having to refill and purge the system once completed. This backflush system and related operational procedure can significantly reduce the downtime and labor hours invested in the backflush process for a data center.

The present backflush circuit can offer significant benefit to customers. It can help protect a customer's investment by offering improved maintenance technology. Such a backflush circuit can readily be sold as a retrofit to existing cooling systems where backflush capabilities may be desired, as well as being included as an additional feature on any new cooling systems.

FIG. 1 illustrates a thermal cooling system 100, in accordance with an example of the present disclosure. In an example, the thermal cooling system 100 is a liquid-cooling-based heat exchanger system. The thermal cooling system 100 can generally include a liquid-cooling circuit 102 (e.g., liquid circuit, as depicted in FIG. 1), a refrigerant circuit 104, a heat exchanger 106 (e.g., a brazed plate heat exchanger (BPHE), per the illustrated example), and a liquid flush circuit 108. The liquid-cooling circuit 102 can include a fluid pump 110, a coolant distribution unit (CDU) 112, and a series of first fluid interconnects 114 (e.g., plumbing lines in a form of piping and/or tubing), facilitating the fluid interconnection of the heat exchanger 106, the fluid pump 110, the CDU 112, and the liquid flush circuit 108 in a full fluid circuit. The liquid-cooling circuit 102 may further include a standard filter 115 positioned between the heat exchanger 106 and the fluid pump 110 within the fluid path of the liquid-cooling circuit 102. The refrigerant circuit 104 can include a compressor 116, a condenser 118, an expansion valve 120 (e.g., a thermostatic expansion valve (TXV); or an electronic expansion valve (EEV)), and a series of second fluid interconnects 121 (e.g., plumbing lines in a form of piping or tubing), facilitating the fluid interconnection of the heat exchanger 106, the compressor 116, the condenser 118, and the expansion valve 120, in order, in a full fluid circuit. Finally, the liquid flush circuit 108 (e.g., a backflush circuit) of the present example can include a pair of 3-way valves 122A, 122B, a pair of isolation valves 124A, 124B (e.g., in the form of 2-way valves), a backflush filter 126, a series of third fluid interconnects 127 (e.g., plumbing lines in a form of piping or tubing), facilitating the fluid interconnection of the pair of 3-way valves 122A, 122B, the isolation valves 124A, 124B, and the backflush filter 126, as well as with the first fluid interconnects 114 directly connected to the heat exchanger 106. In examples, the liquid flush circuit 108 may be configured as a standalone or partially standalone set of components that can be coupled to an already existing thermal cooling system 100.

It should be understood that 3-way valves and two-way valves describe a basic functionality of the valves, but does not limit the complexity (e.g., "N-way") of the valves. For example, the 2-way valve 124A could be configured as a 3-way valve that provides the function of a 2-way valve. In another example, the 3-way valve 122A could be configured as a 4-way valve that provides the function of a 3-way valve. Therefore, the above description should not be interpreted as a limitation on the examples of the present disclosure, but merely as an illustration.

In an example, the liquid-cooling circuit 102 and the refrigerant circuit 104 can each operate in a manner as known in the art. The liquid-cooling circuit 102 can remove heat produced, for example, by servers, chips, and/or other components (not shown) in a data center using a cooling liquid configured to be conveyed into and out of the CDU 112 by corresponding first fluid interconnects 114. The liquid-cooling circuit 102 can be configured to convey the liquid warmed at the CDU 112 to the heat exchanger 106 via one or more corresponding first fluid interconnects 114, whereat the warmed liquid can once again be cooled. The liquid-cooling circuit 102 can further include the fluid pump 110, fluidly interconnected with both the heat exchanger 106 and the CDU 112, to facilitate a dynamic flow (e.g., by suction thereto and pumping away therefrom) therebetween to convey the now-cooled liquid back to the CDU 112.

Meanwhile, in an example, the refrigerant circuit 104 can be configured to convey a refrigerant fluid (not shown), upon being warmed at the heat exchanger 106 (e.g., as part of the cooling of the liquid in the liquid-cooling circuit 102), by an appropriate number of second fluid interconnects 121, to the compressor 116 and the condenser 118 to again cool and/or refrigerate the refrigerant fluid carried thereby. It is to be understood that the refrigerant fluid can be in the form of a liquid, a gas, or a mixture of a gas and a liquid. It is to be further understood that the refrigerant fluid can be a single phase or a two-phase refrigerant. The refrigerant fluid may be capable of facilitating heat exchange, at least in part, via a liquid-to-gas phase change. The refrigerant circuit 104 can further include the expansion valve 120 plumbed between the condenser 118 and the heat exchanger 106 via appropriate second fluid interconnects 121. The expansion valve 120 can be configured to precisely control the flow of the refrigerant (now cooled) into the heat exchanger 106. It is to be understood that the heat exchanger 106 may be referred to as an evaporator, in a case where a liquid-to-gas phase change of the refrigerant fluid, at least in part, is used to cool the liquid flowing into the opposite side of the heat exchanger 106. In an example, the heat exchanger 106 can be called a refrigerant-liquid heat exchanger. In an example, a BPHE may be particularly suited for refrigerant-liquid heat exchange.

As stated earlier, during normal operation, fouling (e.g., clogging) of the heat exchanger 106 and, potentially, the related input/output first fluid interconnects 114 associated therewith, on the liquid-cooling circuit 102 side of the operation can occur over extended run times (e.g., several weeks or months of operation). In an example, the heat exchanger 106 can be a plate heat exchanger. In yet a further example, the heat exchanger 106 can be a brazed plate heat exchanger (BPHE), such as illustrated in FIG. 1, which may be particularly employed when using a refrigerant fluid (e.g., a heat exchange fluid capable of a liquid-to-gas phase change for cooling).

The potential for fouling can be even more pronounced when the heat exchanger 106 is in the form of the brazed plate heat exchanger. As also stated previously, that fouling can contribute to a shortened lifetime of those components and/or a decreased efficiency (e.g., in terms of heat exchange capability and/or energy expended for operation thereof) of their operation (especially the heat exchanger 106). Thus, there is a clear need in the art for the present liquid flush circuit 108.

The liquid flush circuit 108 can be configured to selectively operate in a normal cooling operation mode or in a flushing mode, the flushing mode configured to cause the cooling fluid associated with the liquid-cooling circuit 102 to divert through the liquid flush circuit 108, the heat exchanger 106, and through the backflush filter 126 of the liquid flush circuit 108. That is, the backflush filter can be configured to remove particulates, etc., freed by the flushing/cleaning process from the cooling fluid. In an example, the flushing mode can be considered to be a backflush operation (e.g., as the flow of the cooling fluid through the heat exchanger 106 is reversed relative to the normal flow direction, entering through the "back" of the heat exchanger 106).

In an example, the backflush filter 126, in operation, can facilitate removal of particulates not otherwise captured by the standard filter 115. In an example, the backflush filter 126 may be configured to capture smaller particulates than the standard filter 115 (e.g., the standard filter 115 may be designed more to maintain sufficient cooling flow rates, possibly sacrificing some on filtration levels). In an example, the liquid flush circuit 108 may have a reduced flow rate associated therewith relative to the liquid-cooling circuit 102 due to use of a smaller-size particulate filter for the backflush filter 126 compared to the standard filter 115 (e.g., allowing for temporarily reduced flow levels to permit greater levels of filtration to reduce clogging potential in the longer run). In an example, a level of filtration can be maintained during normal operation with the standard filter 115 available, while the backflush filter 126 is offline (e.g., permitting servicing/cleaning backflush filter (after backflush procedure) and/or general operation of the liquid-cooling circuit 102). In an example, having a second filter (i.e., the backflush filter 126) also allows contaminant freed during the backflush process to be isolated to a smaller portion of the liquid-cooling circuit 102 and to the liquid flush circuit 108.

The present liquid flush circuit 108 can include a pair of the 3-way valves 122, with a first 3-way valve 122A located in a first fluid path side 128 (e.g., the entry side in a normal cooling operating mode) of the heat exchanger 106 and the second 3-way valve 122B located in a second fluid path side 130 (e.g., the exit side in a normal cooling operating mode) of the heat exchanger 106. The first 3-way valve 122A can be fluidly connected to CDU 112, the heat exchanger 106, and the second 3-way valve 122B. In turn, the second 3-way valve 122B can be fluidly connected to the fluid pump 110, the heat exchanger 106, and, of course, the first 3-way valve 122A.

The fluid interconnection between the first and second 3-way valves 122A, 122B outside of their respective flow path with the heat exchanger 106, along with the related third fluid interconnects 127, can be considered to define a first divergent section 132 of the liquid flush circuit 108. The isolation valves 124A, 124B, the backflush filter 126, and their related third fluid interconnects 127 can be considered to define a second divergent section 134 of the liquid flush circuit 108. In an example, the isolation valves 124A, 124B can be respectively located one on either side of the backflush filter 126 in the second divergent section 134. In an example, the isolation valves 124A, 124B may be 2-way valves and/or may be positioned in a range extending from proximate to distal to the backflush filter 126 within the second divergent section 134, as desired. The thermal cooling system 100 may include portions 136, 138 of the fluid interconnection 114 that permit a reversal of coolant flow during backflush (e.g., as indicated by the dotted arrows).

The operation of the first divergent section 132 and the second divergent section 134, in conjunction with one another, can selectively determine whether the liquid-cooling circuit 102 is being operated in a normal operational (e.g., cooling) mode or in a flushing (e.g., cleaning) mode. In an example, the first divergent section 132 and the second divergent section 134 can be fluidly connected to first fluid interconnects 114 in respective fluid communication with the first and second fluid path sides 128 of the heat exchanger 106. The first divergent section 132 and the second divergent section 134 can be collectively configured to facilitate the selective backflushing of the heat exchanger 106. It is to be understood that the present liquid flush circuit 108, with its first and second divergent sections 132, 134, can be included on any new thermal cooling system 100 employing liquid cooling, or it can be retrofitted with any such thermal cooling system 100.

With the 3-way valves 122A, 122B and isolation valves 124A, 124B of the liquid flush circuit 108 set in a cooling position, the fluid in the liquid-cooling circuit 102 can flow/circulate through liquid-cooling circuit 102 in a normal operational mode. That is, in a normal operational mode, the isolation valves 124A, 124B can be closed; and the divergent path between the 3-way valves 122A, 122B can also be closed, with the liquid able to flow from the CDU 112 to and through the heat exchanger 106 and onto the fluid pump 110, which can convey the cooling fluid to the CDU 112. In its normal operational mode, the liquid cooling circuit 102 can completely avoid the first divergent section 132 and the backflush filter 126 of the second divergent section 134.

However, with the 3-way valves 122A, 122B and isolation valves 124A, 124B set in a flushing position, the first 3-way valve 122A can be configured to divert the cooling fluid coming from the CDU 112 to the second 3-way valve 123A, with second 3-way valve configured and otherwise settable to redirect flow therefrom back into the heat exchanger 106 and ultimately through the backflush filter 126. This redirection of flow back into the heat exchanger 106 and concordant flow reversal can help flush any build-up (e.g., fouling, clogging) from the heat exchanger 106 and/or the immediate in/out first fluid interconnects 114 associated therewith. In the flushing position, the first 3-way valve 122A can prevent backflow toward the CDU 112, and the isolation valves 124A, 124B can instead be open, permitting the cooling fluid to pass now to and through the backflush filter 126. The backflush filter 126, as configured, can remove most, if not all, the fouling material (e.g., clogging particulates) from the cooling fluid, prior to the cooling fluid reaching a section (one or more) of third fluid interconnects 127 configured to link the backflush filter 126 with one or more first fluid interconnects 114 in fluid communication with the fluid pump 110.

The number of flushing cycles (e.g., through both the main liquid-cooling circuit 102 and the diverging liquid flush circuit 108) needed can vary as needed, and the number of cycles can be a set number of cycles; can be based on a set time; and/or can be based on sensor readings. Such readings can be obtained by sensors (not shown) located within the flow path of the liquid-cooling circuit 102, the liquid flush circuit 108, and/or the heat exchanger 106, measuring, for example, flow rate, particulate levels, fluid viscosity, etc. Upon sufficient flushing, the 3-way valves 122A, 122B and isolation valves 124A, 124B can be reset to a cooling position, with the fluid in the liquid-cooling circuit 102 permitted once again to flow through liquid-cooling circuit 102 in a normal operational (e.g., cooling) mode, until such time flushing thereof is again enabled. It is to be understood that, in an example, the backflush filter 126 and, as needed, the liquid flush circuit 108, in conjunction with the backflush filter 126 (e.g., placement and operation of one or more additional valves (not shown) to prevent flow to the backflush filter 126), may be configured to facilitate the cleaning and/or replacement of the backflush filter 126, as desired.

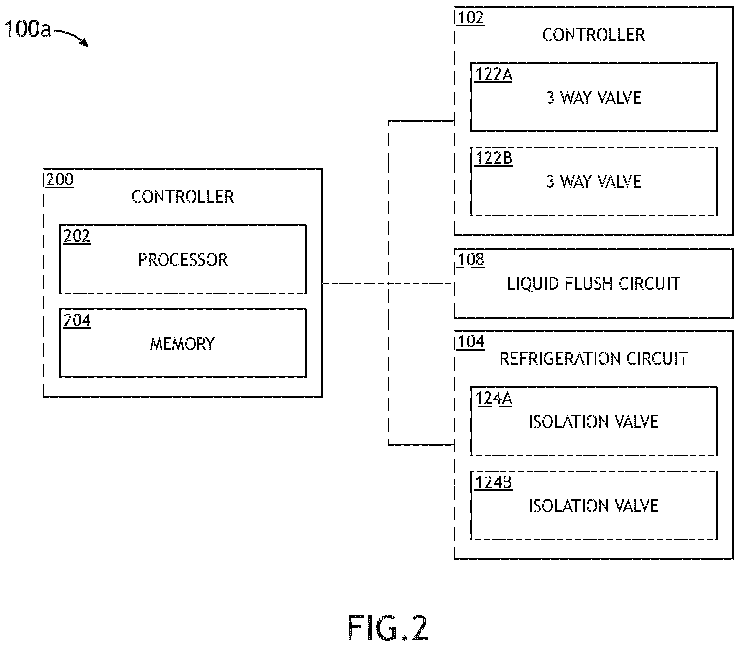

FIG. 2 illustrates a block diagram depicting a thermal cooling system 100a, in accordance with one or more examples of the disclosure. The thermal cooling system 100a may include one or more components of the thermal cooling system 100, and vice versa. The thermal cooling system 100a may include at least one controller 200 (e.g., containing at least one processor 202 and memory 204) for controlling the operation of the various components of the system 100a, whether in the liquid-cooling circuit 102, the refrigerant circuit 104, and/or the liquid flush circuit 108 (e.g., the 3-way valves 122A, 122B; and the isolation valves 124A, 124B thereof).

For example, the at least one processor 202 may be communicatively coupled to at least one of the first 3-way valve 122A, the second 3-way valve 122B, or one or more of the two-way valves 124A, 124B. For instance, the memory 204 may include instructions that, when executed by the one or more processors 202, causes the at least one of the first 3-way valve 124A, the second 3-way valve 124B, or the one or more two-way valves 124A, 124B to change a valve setting (e.g., from OFF to ON) that causes the selective backflushing of the heat exchanger 106.

The at least one processor 202 may be implemented as any suitable processor(s), such as at least one general purpose processor, at least one central processing unit (CPU), at least one image processor, at least one graphics processing unit (GPU), at least one field-programmable gate array (FPGA), and/or at least one special purpose processor configured to execute instructions for performing (e.g., collectively performing if more than one processor) any or all of the operations disclosed throughout.

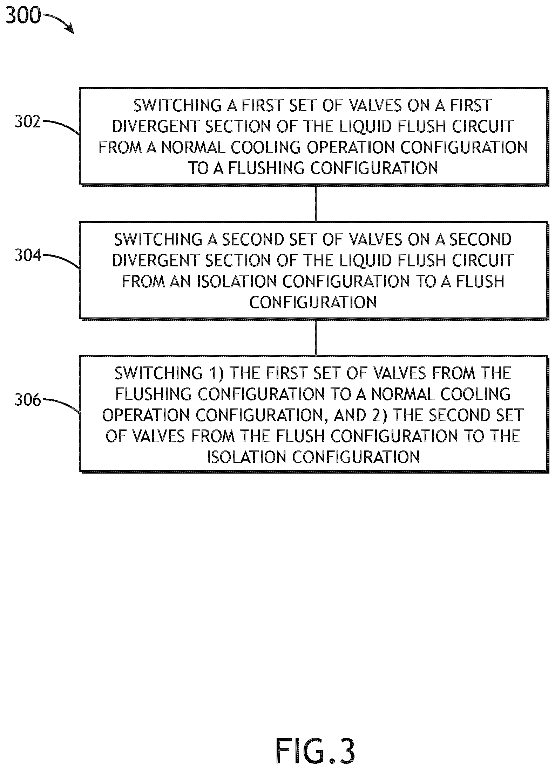

FIG. 3 illustrates a process flow diagram depicting a method 300 for backflushing a portion of a thermal cooling system 100, 100a, in accordance with one or more examples of the disclosure. For example, the method 300 may be used to backflush a portion of the liquid-cooling circuit 102, the refrigerant circuit 104, and/or the liquid flush circuit 108. For instance, the method 300 may be used to backflush the heat exchanger 106.

In examples, the method 300 includes a step 302 of switching a first set of valves (e.g., 3-way valves 122A, 122B) on a first divergent section 132 of the liquid flush circuit 108 from a normal cooling operation configuration to a flushing configuration. For example, switching the first set of valves may cause a flow of liquid into a first divergent section 132 of the liquid flush circuit 108. The switching of the first set of valves may also cause a reversed flow of liquid into a portion 136, 138 of a fluid interconnection 114, wherein the reversed flow of liquid into the portion 136, 138 of the fluid interconnection 114 produces a flushed liquid. For instance, the switching of the 3-way valves 122A, 122B may cause fluid to reverse flow upon fluid lines at or near the heat exchanger 106, reverse flushing the heat exchanger 106, and producing a flushed liquid that may contain materials (e.g., contaminants) that have been flushed out of the heat exchanger 106.

In examples, the method 300 includes a step 304 of switching a second set of valves (isolation valves 124A, 124B) on a second divergent section 134 of the liquid flush circuit 108 from an isolation configuration to a flush configuration. For example, switching a second set of valves (isolation valves 124A, 124B) on a second divergent section 134 of the liquid flush circuit 108 from an isolation configuration to a flush configuration may cause a flow of the flushed liquid into the second divergent section 134. The step 304 may further cause a flow of flushed fluid through a backflush filter 126 positioned along the second divergent section 134, wherein the flow of flushed fluid through the backflush filter 124 produces filtered fluid. The step 304 may further cause a flow of the filtered fluid into the liquid circuit 102. Step 302 and step 304 may be performed concurrently, otherwise synchronized to permit stable flow of liquid coolant.

In examples, the method 300 includes a step 306 of switching 1) the first set of valves (e.g., 3-way valves 122A, 122B) from the flushing configuration to a normal cooling operation configuration, and 2) the second set of valves (isolation valves 124A, 124B) from the flush configuration to the isolation configuration. For example, switching the first set of valves from the flushing configuration to a normal cooling operation configuration, and the second set of valves from the flush configuration to the isolation configuration may cause the thermal cooling system 100, 100a to selectively flow liquid through the liquid circuit 102 (e.g., bypassing the liquid flush circuit 108).

In one example, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the examples disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative example of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application-specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

As used throughout and as would be appreciated by those skilled in the art, "at least one non-transitory computer-readable medium" or "memory" may refer to as at least one non-transitory computer-readable medium (e.g., at least one computer-readable medium implemented as hardware); at least one non-transitory processor-readable medium, at least one memory (e.g., at least one nonvolatile memory, at least one volatile memory, or a combination thereof); e.g., at least one random-access memory, at least one flash memory, at least one read-only memory (ROM) (e.g., at least one electrically erasable programmable read-only memory (EEPROM)), at least one on-processor memory (e.g., at least one on-processor cache, at least one on-processor buffer, at least one on-processor flash memory, at least one on-processor EEPROM, or a combination thereof), or a combination thereof), at least one storage device (e.g., at least one hard-disk drive, at least one tape drive, at least one solid-state drive, at least one flash drive, at least one readable and/or writable disk of at least one optical drive configured to read from and/or write to the at least one readable and/or writable disk, or a combination thereof), or a combination thereof.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary.

Further examples are set out in the items below:
1.A thermal cooling system, comprising:
   a liquid-cooling circuit configured to convey a cooling fluid therethrough;
   a heat exchanger fluidly coupled with the liquid-cooling circuit; and
   a liquid flush circuit fluidly coupled with the liquid-cooling circuit, the liquid flush circuit including a filter, the liquid flush circuit configured to selectively operate in a normal cooling operation mode or in a flushing mode, the flushing mode configured to cause the cooling fluid to divert through the liquid flush circuit and the heat exchanger to cause the cooling fluid to flow through the filter after passing through the heat exchanger.
2. The thermal cooling system of item 1, wherein the liquid flush circuit further includes a first 3-way valve and a second 3-way valve, selectively fluidly interconnected with each other and with the heat exchanger.
3. The thermal cooling system of item 2, wherein the first 3-way valve, the second 3-way valve, and the fluid interconnection therebetween define, at least in part, a first divergent section of the liquid flush circuit, the first divergent section selectively fluidly interconnected with the liquid-cooling circuit.
4. The thermal cooling system of item 3, further comprising a two-way valve, the two-way valve selectively fluidly interconnected with the filter, the two-way valve, the filter, and the fluid interconnection therebetween defining, at least in part, a second divergent section of the liquid flush section, the second divergent section further selectively fluidly connected with the liquid-cooling circuit.
5.The thermal cooling system of item 4, wherein the first divergent section and the second divergent section are collectively configured to facilitate the selective backflushing of the heat exchanger.
Further examples are set out in the clauses below:
1. A thermal cooling system, comprising:
   a liquid-cooling circuit configured to convey a cooling fluid therethrough;
   a heat exchanger fluidly coupled with the liquid-cooling circuit; and
   a liquid flush circuit fluidly coupled with the liquid-cooling circuit, the liquid flush circuit including a filter, the liquid flush circuit configured to selectively operate in a normal cooling operation mode or in a flushing mode, the flushing mode configured to cause the cooling fluid to divert through the liquid flush circuit and the heat exchanger to cause the cooling fluid to flow through the filter after passing through the heat exchanger.
2. The thermal cooling system of clause 1, wherein the liquid flush circuit further includes a first 3-way valve and a second 3-way valve, selectively fluidly interconnected with each other and with the heat exchanger.
3. The thermal cooling system of clause 2, wherein the first 3-way valve, the second 3-way valve, and the fluid interconnection therebetween define, at least in part, a first divergent section of the liquid flush circuit, the first divergent section selectively fluidly interconnected with the liquid-cooling circuit.
4. The thermal cooling system of clause 3, further comprising a two-way valve, the two-way valve selectively fluidly interconnected with the filter, the two-way valve, the filter, and the fluid interconnection therebetween defining, at least in part, a second divergent section of the liquid flush section, the second divergent section further selectively fluidly connected with the liquid-cooling circuit.
5. The thermal cooling system of clause 4, wherein the first divergent section and the second divergent section are collectively configured to facilitate a selective backflushing of the heat exchanger.
6. The thermal cooling system of clause 5, further comprising one or more processors and memory, wherein the one or more processors are communicatively coupled to at least one of the first 3-way valve, the second 3-way valve, or the two-way valve, wherein the memory comprises instructions that, when executed by the one or more processors, causes the at least one of the first 3-way valve, the second 3-way valve, or the two-way valve to change a valve setting, wherein changing the valve setting causes the selective backflushing of the heat exchanger.
7. The thermal cooling system of any one of the previous clauses, wherein the heat exchanger comprises a brazed plate heat exchanger.
8. The thermal cooling system of any one of the previous clauses, wherein the liquid-cooling system is configured to remove heat from one or more servers from a data center.
9. The thermal cooling system of any one of the previous clauses, wherein the cooling fluid does not flow through the filter when the thermal cooling system is operating in the normal cooling operation mode.
9A. A system comprising:
   a liquid flush circuit fluidly couplable to a liquid cooling circuit of the thermal cooling system of any one of claims 1-9.
10. A system comprising:
   a liquid flush circuit fluidly couplable to a liquid cooling circuit of a thermal cooling system, wherein the liquid cooling circuit includes a heat exchanger, the liquid flush circuit comprising:
   a fluid interconnection; and
   a filter, wherein the liquid flush circuit is configured to selectively operate in a normal cooling operation mode or in a flushing mode, the flushing mode configured to cause the cooling fluid to divert through the liquid flush circuit and the heat exchanger to cause the cooling fluid to flow through the filter after passing through the heat exchanger.
11. The system of clause 10, wherein the liquid flush circuit further includes a first 3-way valve and a second 3-way valve, selectively fluidly interconnected with each other and with the heat exchanger.
12. The system of clause 11, wherein the first 3-way valve, the second 3-way valve, and the fluid interconnection therebetween define, at least in part, a first divergent section of the liquid flush circuit, the first divergent section selectively fluidly interconnected with a liquid-cooling circuit.
13. The system of clause 12, further comprising a two-way valve, the two-way valve selectively fluidly interconnected with the filter, the two-way valve, the filter, and the fluid interconnection therebetween defining, at least in part, a second divergent section of the liquid flush section, the second divergent section further selectively fluidly connected with the liquid-cooling circuit.
14. The system of clause 13, wherein the first divergent section and the second divergent section are collectively configured to facilitate a selective backflushing of the heat exchanger.
15. The system of clause 14, further comprising one or more processors and memory, wherein the one or more processors are communicatively coupled to at least one of the first 3-way valve, the second 3-way valve, or the two-way valve, wherein the memory comprises instructions that, when executed by the one or more processors, causes the at least one of the first 3-way valve, the second 3-way valve, or the two-way valve to change a valve setting, wherein changing the valve setting causes the selective backflushing of the heat exchanger.
16. The system of clause 14 or 15, wherein the heat exchanger comprises a brazed plate heat exchanger.
17. The system of any one of clauses 14-16, wherein the liquid-cooling system is configured to remove heat from one or more servers from a data center.
18. The system of any one of the previous clauses, wherein the cooling fluid does not flow through the filter when the thermal cooling system is operating in the normal cooling operation mode.
19. A method for backflushing a thermal cooling system containing a liquid circuit and a liquid flush circuit, comprising:
   switching a first set of valves on a first divergent section of the liquid flush circuit from a normal cooling operation configuration to a flushing configuration, wherein switching the first set of valves causes:
   a flow of liquid into a first divergent section of the liquid flush circuit; and
   a reversed flow of liquid into a portion of a fluid interconnection of the liquid circuit
   wherein the reversed flow of liquid into the portion of the fluid interconnection of the liquid circuit produces a flushed liquid;
   switching a second set of valves on a second divergent section of the liquid flush circuit from an isolation configuration to a flush configuration, wherein switching the second set of valves causes:
      a flow of the flushed liquid into the second divergent section;
      a flow of flushed fluid through a backflush filter positioned along the second divergent section, wherein the flow of flushed fluid through the backflush filter produces filtered fluid; and
      a flow of the filtered fluid into the liquid circuit; and
      switching 1) the first set of valves from the flushing configuration to a normal cooling operation configuration, and 2) the second set of valves from the flush configuration to the isolation configuration, wherein switching the first set of valves from the flushing configuration to a normal cooling operation configuration, and the second set of valves from the flush configuration to the isolation configuration causes the thermal cooling system to selectively flow liquid through the liquid circuit.
20. The method of clause 19, wherein the portion of the fluid interconnection comprises a heat exchanger.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A thermal cooling system, comprising:
a liquid-cooling circuit configured to convey a cooling fluid therethrough;
a heat exchanger fluidly coupled with the liquid-cooling circuit; and
a liquid flush circuit fluidly coupled with the liquid-cooling circuit, the liquid flush circuit including a filter, the liquid flush circuit configured to selectively operate in a normal cooling operation mode or in a flushing mode, the flushing mode configured to cause the cooling fluid to divert through the liquid flush circuit and the heat exchanger to cause the cooling fluid to flow through the filter after passing through the heat exchanger.

2. The thermal cooling system of claim 1, wherein the liquid flush circuit further includes a first 3-way valve and a second 3-way valve, selectively fluidly interconnected with each other and with the heat exchanger.

3. The thermal cooling system of claim 2, wherein the first 3-way valve, the second 3-way valve, and the fluid interconnection therebetween define, at least in part, a first divergent section of the liquid flush circuit, the first divergent section selectively fluidly interconnected with the liquid-cooling circuit.

4. The thermal cooling system of claim 3, further comprising a two-way valve, the two-way valve selectively fluidly interconnected with the filter, the two-way valve, the filter, and the fluid interconnection therebetween defining, at least in part, a second divergent section of the liquid flush section, the second divergent section further selectively fluidly connected with the liquid-cooling circuit.

5. The thermal cooling system of claim 4, wherein the first divergent section and the second divergent section are collectively configured to facilitate a selective backflushing of the heat exchanger.

6. The thermal cooling system of claim 5, further comprising one or more processors and memory, wherein the one or more processors are communicatively coupled to at least one of the first 3-way valve, the second 3-way valve, or the two-way valve, wherein the memory comprises instructions that, when executed by the one or more processors, causes the at least one of the first 3-way valve, the second 3-way valve, or the two-way valve to change a valve setting, wherein changing the valve setting causes the selective backflushing of the heat exchanger.

7. The thermal cooling system of any one of the preceding claims, wherein the heat exchanger comprises a brazed plate heat exchanger; or optionally
wherein the liquid-cooling system is configured to remove heat from one or more servers from a data center; or optionally
wherein the cooling fluid does not flow through the filter when the thermal cooling system is operating in the normal cooling operation mode.

8. A system comprising:
a liquid flush circuit fluidly couplable to a liquid cooling circuit of a thermal cooling system as claimed in claim 1.

9. The system of claim 8, wherein the liquid flush circuit further includes a first 3-way valve and a second 3-way valve, selectively fluidly interconnected with each other and with the heat exchanger.

10. The system of claim 9, wherein the first 3-way valve, the second 3-way valve, and the fluid interconnection therebetween define, at least in part, a first divergent section of the liquid flush circuit, the first divergent section selectively fluidly interconnected with a liquid-cooling circuit.

11. The system of claim 10, further comprising a two-way valve, the two-way valve selectively fluidly interconnected with the filter, the two-way valve, the filter, and the fluid interconnection therebetween defining, at least in part, a second divergent section of the liquid flush section, the second divergent section further selectively fluidly connected with the liquid-cooling circuit.

12. The system of claim 11, wherein the first divergent section and the second divergent section are collectively configured to facilitate a selective backflushing of the heat exchanger.

13. The system of claim 12, further comprising one or more processors and memory, wherein the one or more processors are communicatively coupled to at least one of the first 3-way valve, the second 3-way valve, or the two-way valve, wherein the memory comprises instructions that, when executed by the one or more processors, causes the at least one of the first 3-way valve, the second 3-way valve, or the two-way valve to change a valve setting, wherein changing the valve setting causes the selective backflushing of the heat exchanger; or optionally
wherein the heat exchanger comprises a brazed plate heat exchanger; or optionally
wherein the liquid-cooling system is configured to remove heat from one or more servers from a data center; or optionally
wherein the cooling fluid does not flow through the filter when the thermal cooling system is operating in the normal cooling operation mode.

14. A method for backflushing a thermal cooling system containing a liquid circuit and a liquid flush circuit, comprising:
switching a first set of valves on a first divergent section of the liquid flush circuit from a normal cooling operation configuration to a flushing configuration, wherein switching the first set of valves causes:
a flow of liquid into a first divergent section of the liquid flush circuit; and
a reversed flow of liquid into a portion of a fluid interconnection of the liquid circuit, wherein the reversed flow of liquid into the portion of the fluid interconnection of the liquid circuit produces a flushed liquid;
switching a second set of valves on a second divergent section of the liquid flush circuit from an isolation configuration to a flush configuration, wherein switching the second set of valves causes:
a flow of the flushed liquid into the second divergent section;
a flow of flushed fluid through a backflush filter positioned along the second divergent section, wherein the flow of flushed fluid through the backflush filter produces filtered fluid; and
a flow of the filtered fluid into the liquid circuit; and
switching 1) the first set of valves from the flushing configuration to a normal cooling operation configuration, and 2) the second set of valves from the flush configuration to the isolation configuration, wherein switching the first set of valves from the flushing configuration to a normal cooling operation configuration, and the second set of valves from the flush configuration to the isolation configuration causes the thermal cooling system to selectively flow liquid through the liquid circuit.

15. The method of claim 14, wherein the portion of the fluid interconnection comprises a heat exchanger.
